# EUROPEAN PATENT APPLICATION

(11) **EP 1 884 790 A1**
(43) Date of publication of application: **06.02.2008**
(21) Application number: 07015204.6
(22) Date of filing: 02.08.2007
(51) Int. Cl.: G01R 31/36

(54) **Battery monitoring device and batteries**

(30) Priority: 02.08.2006 JP 2006210513
(71) Applicant: Shin-Kobe Electric Machinery Co., Ltd., Chuo-ku Tokyo 104-0044 (JP)
(72) Inventor: Kawata, Takahiro, Chiyoda-ku Tokyo 100-8220 (JP); Emori, Akihiko, Chiyoda-ku Tokyo 100-8220 (JP); Kawahara, Youhei, Chiyoda-ku Tokyo 100-8220 (JP); Arita, Hiroshi, Chiyoda-ku Tokyo 100-8220 (JP)
(74) Representative: Strehl Schübel-Hopf & Partner

(57) **Abstract**

A communication means (105) of a battery monitoring device (101) receives setting information (measuring parameters) about the type or structure of a storage battery (102) to be monitored from a host system (106). A setting means (107) acquires the measuring parameters and performs setting for a measuring means (103) and a digital signal conversion means (104). In other words, the setting means (107) sets, in accordance with the type or structure of the storage battery (102), the measuring parameters (namely, the measuring time interval, the measuring channel number, the measurement range and the like) for the measuring means (103) and the digital signal conversion means (104). Thus, even when the type and construction of the storage battery (102) changes, state of charge and the like of the storage battery (102) can be accurately measured and monitored by the battery monitoring device (101).

## Description

### BACKGROUND OF THE INVENTION

### 1. Field of the Invention

The present invention relates to a battery monitoring device for monitoring the state of charge, the residual capacity and the like of a storage battery, and a storage battery to be monitored.

### 2. Description of the Related Art

A hybrid vehicle or an electric vehicle which runs using a power supply device employing a storage battery is generally equipped with a battery controller or a battery monitoring device which detects the state of the storage battery and controls the storage battery, so that the storage battery can be used safely and efficiently. The items to be detected include an SOC (the state of charge) which indicates how much the storage battery is charged, a residual capacity which indicates how much dischargeable electrical charge remains in the storage battery, and an SOH (state of health) which indicates a deterioration condition of the storage battery.

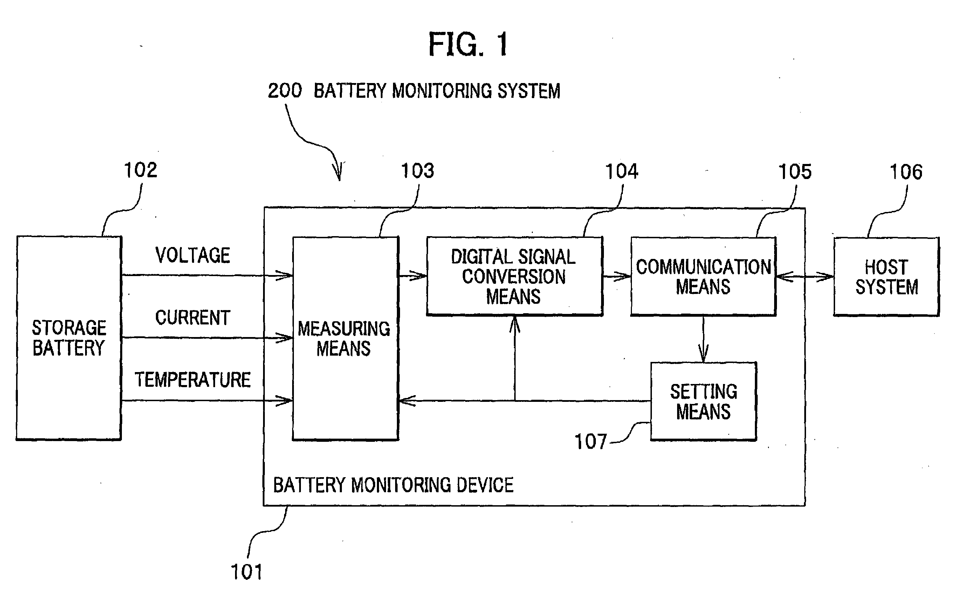

For example, in the case where the storage battery is used in a hybrid vehicle, the battery controller performs state detecting such as the SOC and SOH of the storage battery and transmits the detection result to a host system such as a vehicle controller through a CAN (Controller Area Network) which is one of communication protocols for control device. The vehicle controller utilises the storage battery in accordance with the state of the storage battery. On the other hand, the battery monitoring device detects the voltage, the current, and the temperature of the storage battery and executes operation according to the state such as SOC and SOH with a microcomputer (see Patent Document 1: Japanese Patent Laid-Open Publication No. Hei08-313606, paragraphs [0009] to [0022], Figs. 1 to 2; and Patent Document 2: Japanese Patent Laid-Open Publication No. 2002-243813, paragraphs [0009] to [0023], Figs. 1 to 7). Also disclosed is an integrated circuited battery monitoring device capable of monitoring the voltage, the current, and the temperature of the storage battery with a CPU (see Patent Document 3: Japanese Patent Laid-Open Publication No. 2004-301781, paragraphs [0020] to [0028], Fig. 1).

However, in addition to the microcomputer (a computing means), the battery monitoring device disclosed in the Patent Document 1 and Patent Document 2 has many other peripheral elements each formed as an IC or a discrete parts, such as a voltage regulator IC for generating a power supply voltage, a quartz resonator or ceramic resonator for generating a clocking signal, a measuring means for measuring the state of the storage battery, an A/D converter (a digital signal conversion means), a reference voltage generator and the like. Thus, the number of the components constituting the battery monitoring device becomes large, and thereby the device becomes large in size.

According to the Patent Document 3, in order to reduce the number of the components, the measuring means, the digital signal conversion means, the communication means and the computing means necessary for implementing the battery monitoring device can be integrated into a semiconductor integrated device (IC) by integrating the peripheral elements into a single chip, or by hybrid-integrating the peripheral elements to form a SiP (system in package). Although the battery monitoring device disclosed in Patent Document 3 can detect and monitor the voltage, the current, and the temperature of the storage battery having the same type or structure, it can not detect and monitor the storage batteries of different types (for example, a lead-acid battery and a Li ion battery are different type storage batteries) or different structures in which cells are connected in series or in parallel. In other words, although the battery monitoring device disclosed in Patent Document 3 can be made small by incorporating IC technology, it can not detect and monitor the storage battery according to measuring parameters (for example, a measuring time interval, a measuring channel number, a measurement range and the like) established corresponding to the type or structure of the storage battery.

### SUMMARY OF THE INVENTION

In view of the above problems, an object of the present invention is to provide a battery monitoring device capable of detecting and monitoring the state of a storage battery in accordance with the type or structure of the storage battery, and a storage battery to be monitored.

A battery monitoring device according to an aspect of the present invention is constituted as an IC such as an IC chip or a hybrid IC, in which a setting means sets measuring parameters corresponding to the type or structure of the storage battery to be monitored, based on information received from an external device such as a host system by a communication means of the battery monitoring device or based on digital information expressed by fixed potential applied to an IC terminal (a plurality of pins). Since the measuring parameters are set in the above manner, even if the type or structure of the storage battery being detected and monitored changes, the voltage, the current, and the temperature of the storage battery can be automatically measured with the single battery monitoring device.

### BRIEF DESCRIPTION OF THE DRAWINGS

Figs. 1 to 12 are diagrams showing the configuration of a battery monitoring system according to twelve embodiments of the present invention.

### DETAILED DESCRIPTION OF PREFERRED EMBODIMENT(S)

### [Brief of Invention]

A battery monitoring device of the present invention for measuring the voltage, current and temperature of a storage battery is formed by the same IC, and measuring parameters corresponding to the type or structure of the storage battery to be measured can be set based on communication received from a host system or based on digital information, which is expressed by fixed potential, applied to an IC terminal. In other words, a measuring time interval, a measuring channel number and a measurement range for measuring the voltage, the current, and the temperature of the storage battery can be set in accordance with the type or structure of the storage battery based on the communication from the host system or based on the digital information applied to the IC terminal. With such an arrangement, the number of components can be reduced, which contributes to space saving and high reliability. Also, the battery monitoring device having such an arrangement can be used to monitor various types of storage batteries.

Preferred embodiments of the battery monitoring device according to the present invention will be described below with reference to the attached drawings. Note that, to facilitate the description, the following embodiments will be described based on a battery monitoring system having a storage battery, a battery monitoring device and a host system.

### [First Embodiment]

Fig. 1 is a diagram showing a configuration of a battery monitoring system according to a first embodiment of the present invention. As shown in Fig. 1, a battery monitoring system 200 includes a battery monitoring device 101, a storage battery 102 and a host system 106. The battery monitoring device 101 includes a measuring means 103, a digital signal conversion means 104, a communication means 105 and a setting means 107. The battery monitoring device 101 is constituted as a semiconductor integrated device (IC) integrated into a chip or a SiP.

The storage battery 102 is constituted as a device having power storage function such as a lead-acid battery, a Nickel-Metal Hydride battery, a Li ion battery, and a fuel cell. The measuring means 103 includes a sensor for measuring at least one of the voltage, the current and the temperature (which are items to be measured) of the storage battery 102, and an electric/electronic circuit. The digital signal conversion means 104 includes an A/D converter for converting the measured value of the storage battery 102 measured by the measuring means 103 from an analog signal to a digital signal.

The communication means 105 is constituted as a circuit for communicating a serial signal through a CAN (Controller Area Network), a LIN (Local Interconnect Network), an UART (Universal Asynchronous Receiver Transmitter), a Bluetooth (registered trademark) or the like, or constituted as a circuit for communicating an ON-OFF signal of a photocoupler, a relay or the like. The communication means 105 communicates with the host system 106. The host system 106 may be a host controller which uses the storage battery according to the condition of the storage battery. Examples of the host controller include, when being used in a hybrid vehicle, a vehicle controller, a motor controller or the like.

In the battery monitoring device 101, the communication means 105 receives setting information (which will be hereinafter referred to as "measuring parameters" indicating a measuring condition) about the type or structure of the storage battery 102 (which is the object to be monitored) from the host system 106, and the setting means 107 sets the measuring condition of the storage battery 102 for the measuring means 103 and the digital signal conversion means 104 (namely, the setting means 107 sets the measuring parameters). The setting means 107 stores the setting information received by the communication means 105 with a storage circuit such as a flip-flop circuit, a register circuit and a SRAM circuit. Incidentally, the setting information may be the measuring parameters, or may be the type or structure of the storage battery.

Namely, the setting means 107 sets, in accordance with the type or structure of the storage battery 102, the measuring parameters (namely, the measuring time interval, the measuring channel number, the measurement range and the like) for the measuring means 103 and the digital signal conversion means 104. For example, when the storage battery is a lead-acid battery, the measuring parameters are set so that the measuring time interval is 1 ms, the measuring channel number is 5, and the measurement range is 0V to 48V; and when the storage battery is a Li ion battery, the measuring parameters are set so that the measuring time interval is 5 ms, the measuring channel number is 10, and the measurement range is 0V to 42V. The measuring means 103 and the digital signal conversion means 104 operate in accordance with the measuring parameters set by the setting means 107. Incidentally, since the measuring parameters need to be set by the setting means 107 before starting the monitoring of the storage battery 102, the measuring parameters are set at the start time of the battery monitoring device 101.

According to the present embodiment, the battery monitoring device formed by the same IC can be applied to various storage batteries having different types or different structures. Thus, the battery monitoring device formed by the same IC can be used to monitor various storage batteries having different types or different structures, and therefore the number of components can be reduced, which contributes to space saving and high reliability.

### [Second Embodiment]

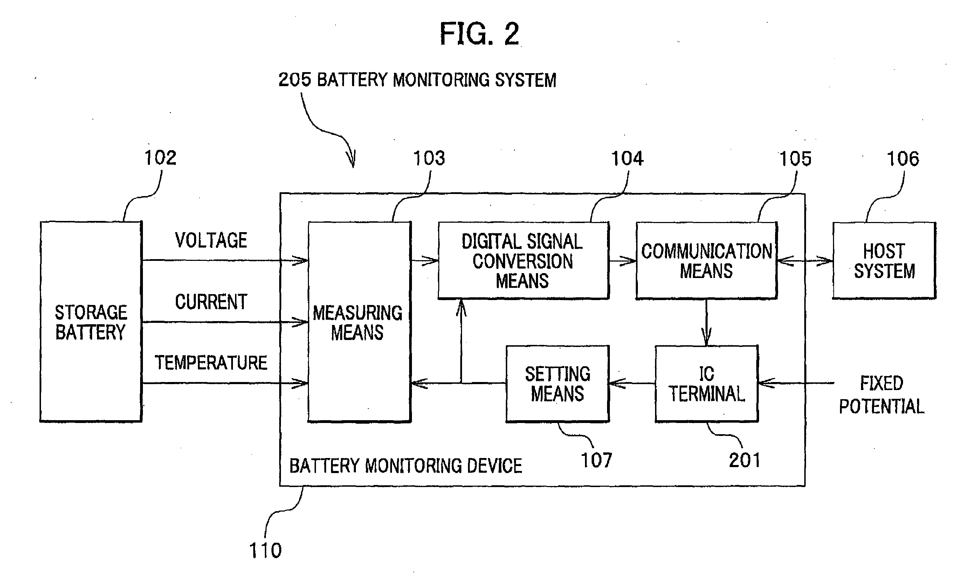

Fig. 2 is a diagram showing a configuration of a battery monitoring system according to a second embodiment of the present invention. As shown in Fig. 2, the battery monitoring system 205 of the second embodiment differs from the battery monitoring system 200 of the first embodiment in that, instead of operating based on the information received through the communication means 105, the setting means 107 sets the measuring parameters for the measuring means 103 and the digital signal conversion means 104 in accordance with the type or structure of the storage battery 102 based on digital information received by an IC terminal 201 of a battery monitoring device 110 which is formed by an IC, the digital information being expressed as a set of fixed potentials of a High (H) level or a Low (L) level applied from outside of the IC.

For example, when the IC terminal 201 receives digital information "0001", the setting means 107 reads out the logic corresponding to the digital information "0001" and converts the logic into the measuring parameters (namely, the measuring time interval, the measuring channel number, the measurement range and the like) corresponding to the type or structure of the storage battery 102 to set the measuring parameters for the measuring means 103 and the digital signal conversion means 104. Note that, to acquire digital information expressed as fixed potential (H/L) from the IC terminal 201, the setting means 107 has a storage circuit such as a flip-flop circuit. Further, instead of receiving the setting information from the host system 106 (as shown in Fig. 1), the communication means 105 transmits the information about the voltage, the current, and the temperature measured by the measuring means 103 to the host system 106 (as shown in Fig. 2).

### [Third Embodiment]

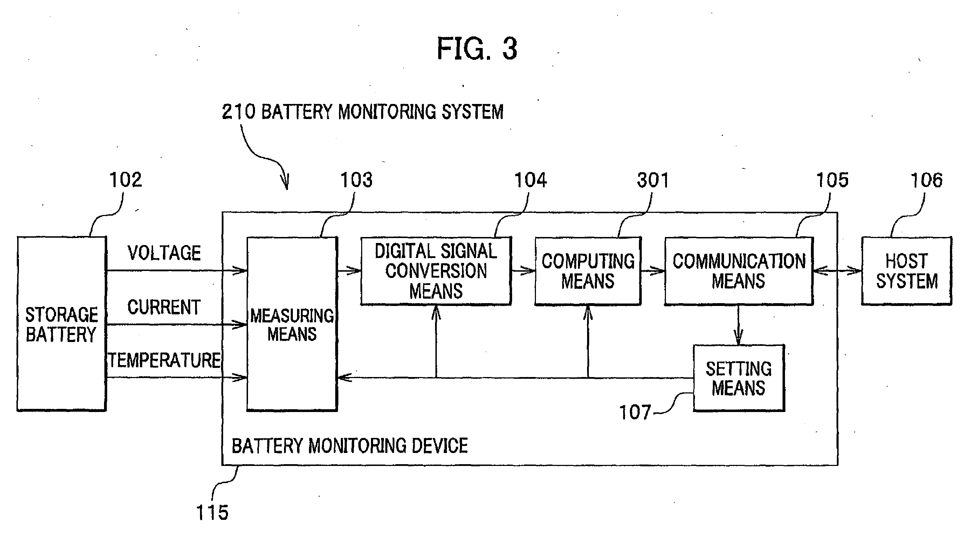

Fig. 3 is a diagram showing a configuration of a battery monitoring system according to a third embodiment of the present invention. The battery monitoring device 115 of the battery monitoring system 210 of the third embodiment (as shown in Fig. 3) differs from the battery monitoring system 200 of the first embodiment (as shown in Fig. 1) in that a communication means 301 is added. The computing means 301 is configured as a microcomputer, a microprocessor, or a logic circuit. The computing means 301 computes the average value, the maximum value and the minimum value of the digital measured value of the voltage, the current and the temperature of the storage battery 102 obtained by the measuring means 103 and the digital signal conversion means 104, and detects the state, such as SOC and SOH of the storage battery 102. For example, in the case where ten pulses of the voltage value of the storage battery 102 are sampled by the measuring means 103, the computing means 301 computes the average value, the maximum value and the minimum value of these sampling pulses. The average value, the maximum value and the minimum value of the voltage, the current and the temperature of the storage battery 102 obtained in such a manner are transmitted from the communication means 105 to the host system 106.

Further, when the communication means 105 has received the setting information (the measuring parameters) about the type or structure of the storage battery 102 from the host system 106, the setting means 107 acquires the setting information (the measuring parameters) from the communication means 105 and sets the measuring parameters for the measuring means 103, the digital signal conversion means 104 and the computing means 301.

### [Fourth Embodiment]

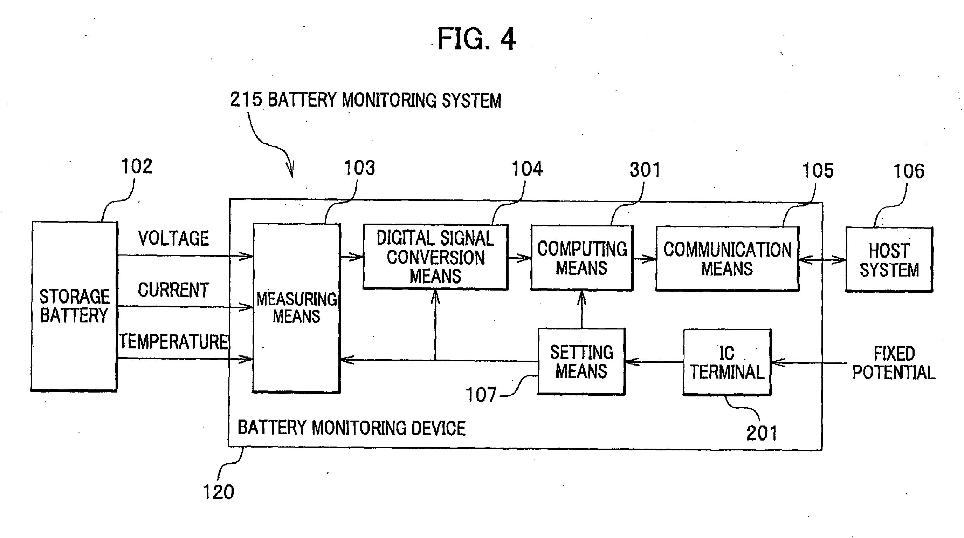

Fig. 4 is a diagram showing a configuration of a battery monitoring system according to a fourth embodiment of the present invention. The battery monitoring device 120 of the battery monitoring system 215 of the fourth embodiment (as shown in Fig. 4) differs from the battery monitoring system 205 of the second embodiment (as shown in Fig. 2) in that a communication means 301 is added. The computing means 301 is identical to the computing means 301 of the third embodiment (as shown in Fig. 3). The computing means 301 computes the average value, the maximum value and the minimum value of the digital measured value of the voltage, the current and the temperature of the storage battery 102, and detects the state such as SOC and SOH of the storage battery 102.

Further, the setting means 107 sets the measuring parameters for the measuring means 103, the digital signal conversion means 104 and the computing means 301 according to the type or structure of the storage battery 102, based on parallel digital information received by the IC terminal 201 of the battery monitoring device 120, the parallel digital information being expressed as a set of fixed potentials (H/L) applied from outside of the IC. Thus, the host system 106 does not have to have a function of transmitting the measuring parameters to the communication means 105.

### [Fifth Embodiment]

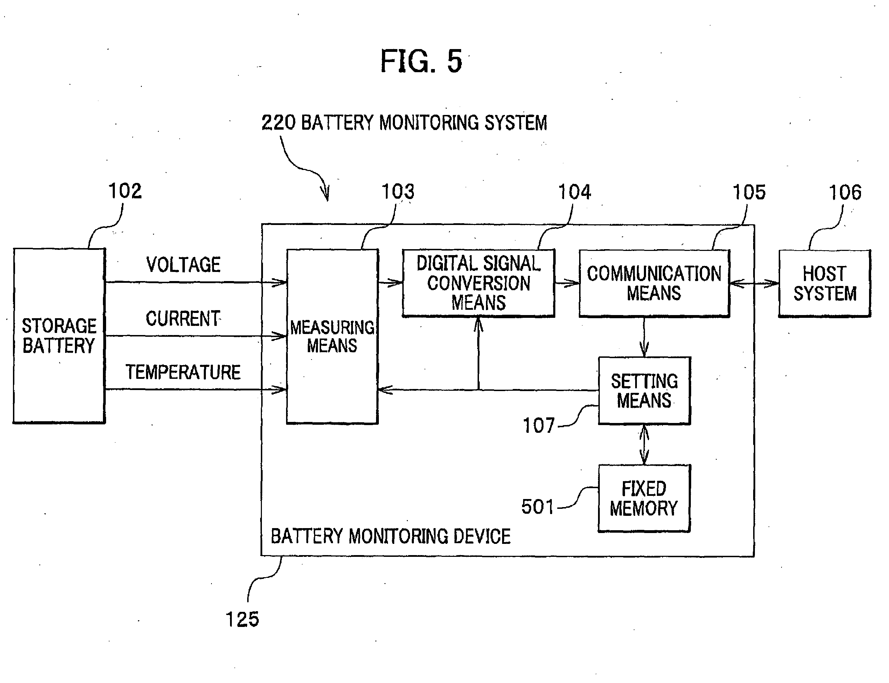

Fig. 5 is a diagram showing a configuration of a battery monitoring system according to a fifth embodiment of the present invention. The battery monitoring device 125 of the battery monitoring system 220 of the fifth embodiment (as shown in Fig. 5) differs from the battery monitoring system 200 of the first embodiment (as shown in Fig. 1) in that a fixed memory 501 is added.

The fixed memory 501 is preliminarily stored with the measuring parameters (namely, the measuring time interval, the measuring channel number, the measurement range and the like) set according to the type or structure of the storage battery 102. Thus, when the communication means 105 receives the information about the type or structure of the storage battery 102 from the host system 106, the setting means 107 refers to the corresponding measuring parameters (namely, the measuring time interval, the measuring channel number, the measurement range and the like) stored in the fixed memory 501 and sets the measuring parameters for the measuring means 103 and the digital signal conversion means 104 based on the information about the type or structure of the storage battery 102 acquired from the communication means 105. Namely, only the information about the type or structure of the storage battery 102 is needed to be transmitted to the communication means 105 by the host system 106, and the measuring parameters about the measuring condition are not necessary to be transmitted to the communication means 105 by the host system 106.

### [Sixth Embodiment]

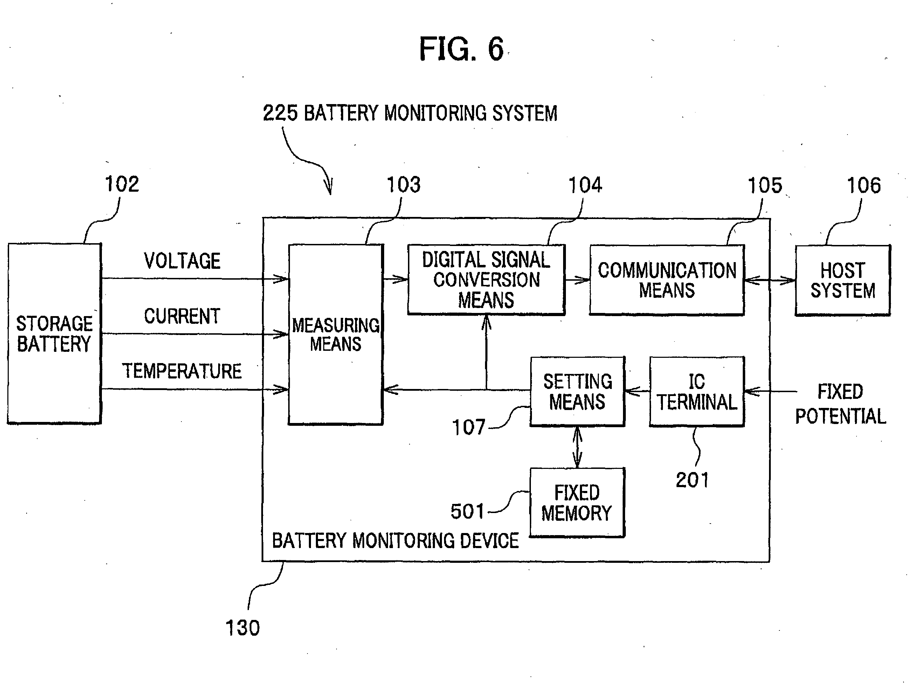

Fig. 6 is a diagram showing a configuration of a battery monitoring system according to a sixth embodiment of the present invention. The battery monitoring device 130 of the battery monitoring system 225 of the sixth embodiment (as shown in Fig. 6) differs from the battery monitoring system 205 of the second embodiment (as shown in Fig. 2) in that a fixed memory 501 is added.

The type or structure of the storage battery 102 is recognised based on the digital information received by the IC terminal 201 of the battery monitoring device 130, the digital information being expressed as a set of fixed potentials (H/L) applied from outside of the IC. The setting means 107 refers to the corresponding measuring parameters (namely, the measuring time interval, the measuring channel number, the measurement range and the like) stored in the fixed memory 501 and sets the measuring parameters for the measuring means 103 and the digital signal conversion means 104 based on the digital information about the type or structure of the storage battery 102 acquired through the IC terminal 201. Namely, the IC terminal 201 does not need to receive the measuring parameters in the form of the parallel digital information expressed as a set of fixed potentials, and the IC terminal 201 only needs to receive the information about the type or structure of the storage battery 102 in the form of the digital information expressed as a set of fixed potentials. In other words, since the IC terminal 201 simply needs to receive simple digital information such as "10", "00" and the like, the number of pins of the terminal can be reduced.

### [Seventh Embodiment]

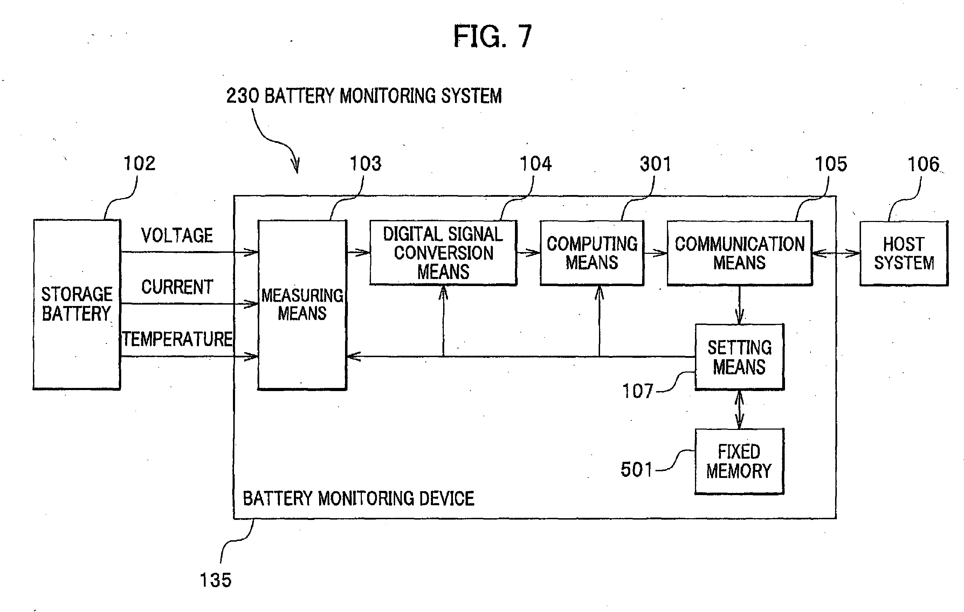

Fig. 7 is a diagram showing a configuration of a battery monitoring system according to a seventh embodiment of the present invention. The battery monitoring device 135 of the battery monitoring system 230 of the seventh embodiment (as shown in Fig. 7) differs from the battery monitoring system 210 of the third embodiment (as shown in Fig. 3) in that a fixed memory 501 is added.

Thus, when the communication means 105 receives the information about the type or structure of the storage battery 102 (which is the object to be monitored) from the host system 106, the setting means 107 refers to the corresponding measuring parameters (namely, the measuring time interval, the measuring channel number, the measurement range and the like) stored in the fixed memory 501 and sets the measuring parameters for the measuring means 103, the digital signal conversion means 104 and the computing means 301 based on the information about the type or structure of the storage battery 102 acquired through the communication means 105. Note that, since the operation performed by the computing means 301 identical to that of the third embodiment (as shown in Fig. 3), the description thereof is skipped here.

### [Eighth Embodiment]

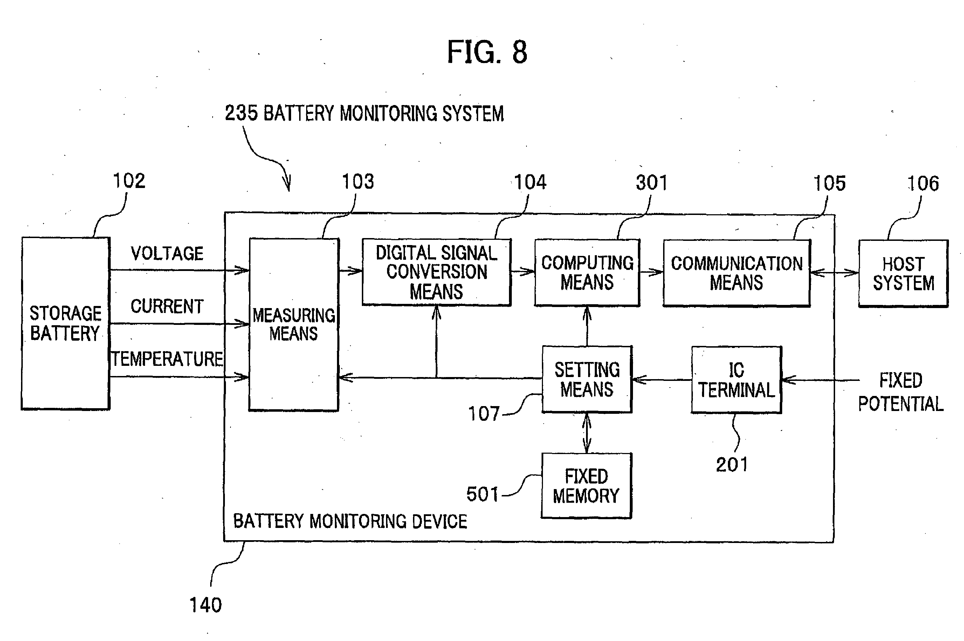

Fig. 8 is a diagram showing a configuration of a battery monitoring system according to an eighth embodiment of the present invention. The battery monitoring device 140 of the battery monitoring system 235 of the eighth embodiment (as shown in Fig. 8) differs from the battery monitoring system 215 of the fourth embodiment (as shown in Fig. 4) in that a fixed memory 501 is added.

When the type or structure of the storage battery 102 is recognised based on the digital information received by the IC terminal 201 of the battery monitoring device 130, the digital information being expressed as fixed potential (H/L) applied from outside of the IC, the setting means 107 refers to the corresponding measuring parameters stored in the fixed memory 501 and sets the measuring parameters for the measuring means 103, the digital signal conversion means 104 and the computing means 301 based on the digital information about the type or structure of the storage battery 102 acquired through the IC terminal 201.

### [Ninth Embodiment]

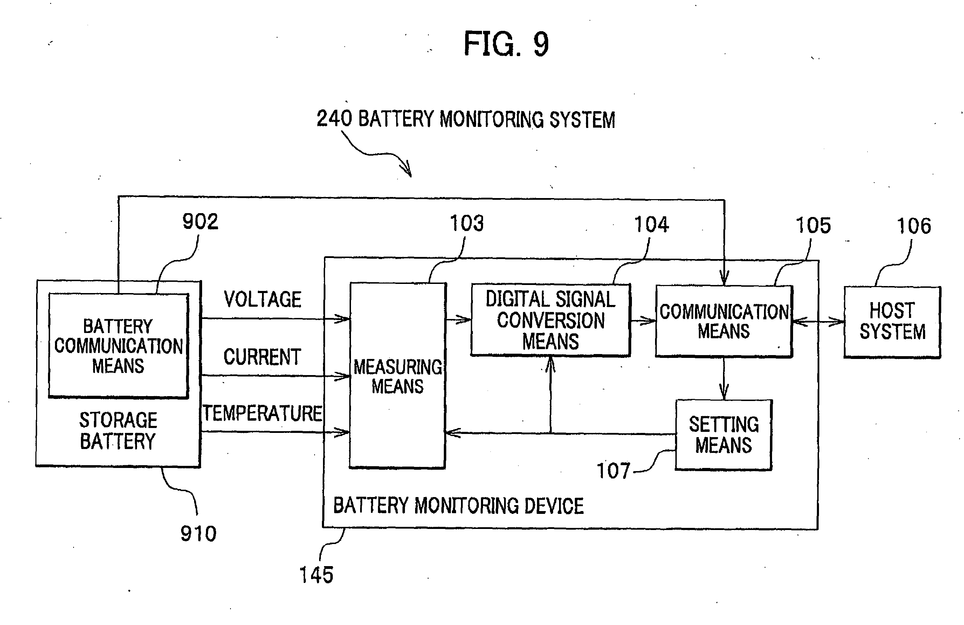

Fig. 9 is a diagram showing a configuration of a battery monitoring system according to a ninth embodiment of the present invention. The configuration of the battery monitoring system 240 of the ninth embodiment (as shown in Fig. 9) differs from that of the battery monitoring system 200 of the first embodiment (as shown in Fig. 1) in that a battery communication means 902 is added to the storage battery 910.

Thus, in the battery monitoring system 240 of the ninth embodiment, instead of receiving the setting information about the type or structure of the storage battery 910 from the host system 106, the communication means 105 of the battery monitoring device 145 receives the setting information (the measuring parameters) about the type or structure of the storage battery 910 from the battery communication means 902 built in the storage battery 910. The setting means 107 sets the measuring parameters for the measuring means 103 and the digital signal conversion means 104 based on the setting information (the measuring parameters) about the type or structure of the storage battery 910 acquired from the communication means 105.

### [Tenth Embodiment]

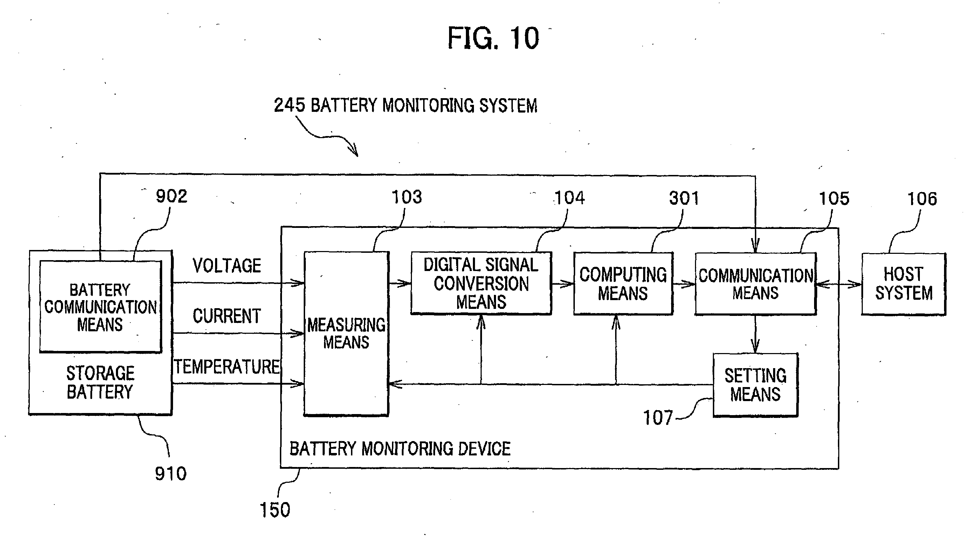

Fig. 10 is a diagram showing a configuration of a battery monitoring system according to a tenth embodiment of the present invention. The battery monitoring system 245 of the tenth embodiment (as shown in Fig. 10) differs from the battery monitoring system 210 of the third embodiment (as shown in Fig. 3) in that a battery communication means 902 is added to the storage battery 910.

Thus, in the battery monitoring system 245, instead of receiving the setting information about the type or structure of the storage battery 910 from the host system 106, the communication means 105 of the battery monitoring device 150 receives the setting information (the measuring parameters) about the type or structure of the storage battery 910 from the battery communication means 902 built in the storage battery 910. Thereby the setting means 107 sets the measuring parameters for the measuring means 103, the digital signal conversion means 104 and the computing means 301.

### [Eleventh Embodiment]

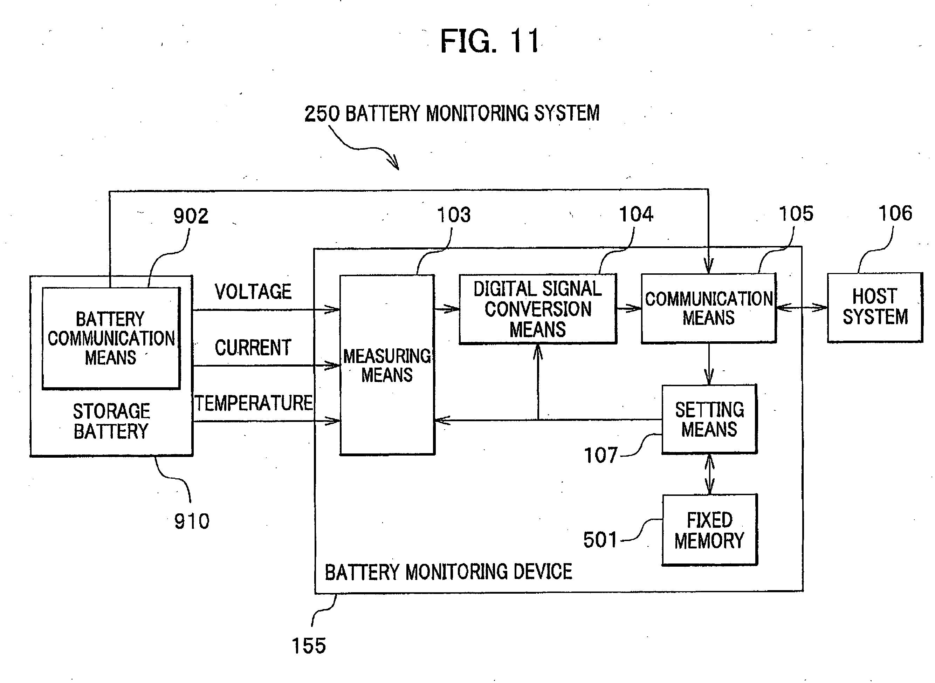

Fig. 11 is a diagram showing a configuration of a battery monitoring system according to an eleventh embodiment of the present invention. The battery monitoring device 155 of the battery monitoring system 250 of the eleventh embodiment (as shown in Fig. 11) differs from the battery monitoring system 240 of the ninth embodiment (as shown in Fig. 9) in that a fixed memory 501 is added.

By the communication from the battery communication means 902 built in the storage battery 910 to the communication means 105 of the battery monitoring device 155, the communication means 105 receives information about the type or structure of the storage battery 910 being monitored. The setting means 107 refers to the corresponding measuring parameters stored in the fixed memory 501 and sets the measuring parameters for the measuring means 103 and the digital signal conversion means 104 based on the information about the type or structure of the storage battery 910 acquired from the communication means 105.

### [Twelfth Embodiment]

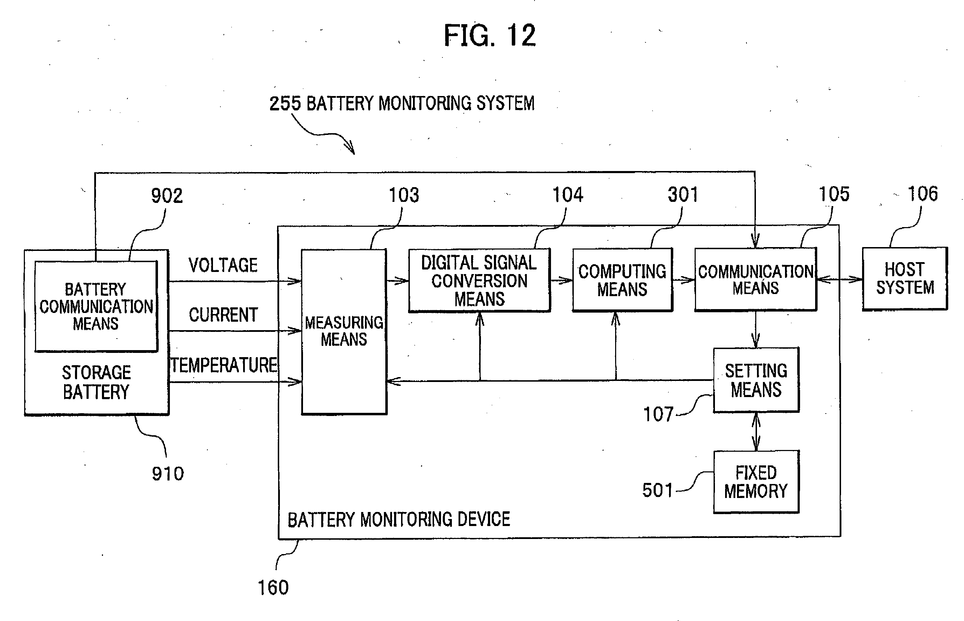

Fig. 12 is a diagram showing a configuration of a battery monitoring system according to a twelfth embodiment of the present invention. The battery monitoring device 160 of the battery monitoring system 255 of the twelfth embodiment (as shown in Fig. 12) differs from the battery monitoring system 245 of the tenth embodiment (as shown in Fig. 10) in that a fixed memory 501 is added.

By the communication from the battery communication means 902 built in the storage battery 910 to the communication means 105 of the battery monitoring device 160, the communication means 105 receives information about the type or structure of the storage battery 910 being monitored. The setting means 107 refers to the corresponding measuring parameters stored in the fixed memory 501 and sets the measuring parameters for the measuring means 103, the digital signal conversion means 104 and the computing means 301 based on the information about the type or structure of the storage battery 910 acquired from the communication means 105.

## Claims

1. An integrated circuited battery monitoring device (101) comprising:
a measuring means (103) for measuring at least one of a voltage, a current and a temperature of a storage battery (102);
a digital signal conversion means (104) for converting a measured analog signal into a digital signal;
a communication means (105) for communicating with outside; and
a setting means (107) which sets measuring parameters according to the type or structure of the storage battery (102) being monitored based on information received from outside by the communication means (105) or digital information input to a plurality of pins of an IC terminal (201).

2. An integrated circuited battery monitoring device (101) comprising:
a measuring means (103) for measuring at least one of a voltage; a current and a temperature of a storage battery (102);
a digital signal conversion means (104) for converting a measured analog signal into a digital signal;
a communication means (105) for communicating with outside;
a setting means (107) which sets measuring parameters according to the type or structure of the storage battery (102) being monitored based on information acquired through the communication means (105) from the storage battery (102).

3. The device of claim lor 2, wherein the measuring parameters include at least one of a measuring time interval, a measuring channel number and a measurement range of the storage battery (102).

4. The device of claim 1, further comprising a fixed memory which stores the measuring parameters therein and provides the measuring parameters in accordance with the information received from outside by the communication means (105) or the digital information applied to the pins.

5. The device of claim 2, further comprising a fixed memory which stores the measuring parameters therein and provides the measuring parameters in accordance with the information acquired by the communication means (105) from the storage battery (102).

6. The device of claim 1 or 2, further comprising a computing means which computes, at predetermined time intervals, the digital measured value of the voltage, the current, and the temperature of the storage battery (102) converted by the digital signal conversion means (104) to obtain a desired value.

7. The device of claim 6, wherein the desired value includes at least one of the average value, the maximum value and the minimum value of the digital measured value of the voltage, the current and the temperature of the storage battery (102) obtain at the predetermined time intervals.

8. The device of claim 1 or 2, wherein the measuring parameters corresponding to the type or structure of the storage battery (102) are set immediately before starting the monitoring of the storage battery (102).

9. A storage battery (102) having at least one of a voltage, a current, and a temperature thereof monitored by a battery monitoring device (101), the storage battery (102) comprising a battery communication means (105) which transmits information about the type or structure of the storage battery (102) to outside.

10. The storage battery (102) of claim 9, wherein the information comprises measuring parameters corresponding to the type or structure of the storage battery (102).
